(19) Europäisches Patentamt / European Patent Office / Office européen des brevets

(11) **EP 3 995 819 A1**

(12) **EUROPEAN PATENT APPLICATION**
published in accordance with Art. 153(4) EPC

(43) Date of publication:
**11.05.2022  Bulletin 2022/19**

(21) Application number: **20835663.4**

(22) Date of filing: **25.06.2020**

(51) International Patent Classification (IPC):
**G01N 22/00** (2006.01)    **G01K 7/32** (2006.01)
**G01N 21/63** (2006.01)    **G01N 24/10** (2006.01)

(52) Cooperative Patent Classification (CPC):
**G01K 7/32; G01N 21/63; G01N 22/00; G01N 24/10**

(86) International application number:
**PCT/JP2020/024945**

(87) International publication number:
**WO 2021/002267 (07.01.2021 Gazette 2021/01)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority:  **03.07.2019  JP 2019124578**

(71) Applicant: **National University Corporation
Okayama University
Kita-ku,
Okayama-shi,
Okayama 700-8530 (JP)**

(72) Inventor: **FUJIWARA, Masazumi
Osaka-shi, Osaka 558-8585 (JP)**

(74) Representative: **Hoffmann Eitle
Patent- und Rechtsanwälte PartmbB
Arabellastraße 30
81925 München (DE)**

(54) **ODMR TEMPERATURE MEASUREMENT METHOD**

(57)    An object is to provide a technique capable of measuring temperature on the basis of optically detected magnetic resonance with higher precision. The object is achieved by a method for measuring the temperature of an object on the basis of optically detected magnetic resonance of an inorganic fluorescent particle, including (a) irradiating the object containing the inorganic fluorescent particle with each of multiple microwaves having different frequencies, (b) measuring the fluorescence intensities of the inorganic fluorescent particle with individual photon counters at the time of irradiation of respective microwaves, (c) correcting the fluorescence intensities on the basis of dependencies in the number of pulse measurements between the photon counters, and (d) calculating the temperature of the object on the basis of the obtained fluorescence intensity with the correction values.

Fig. 1

**Description**

Technical Field

The present invention relates to optically detected magnetic resonance (ODMR) thermometry.

Background Art

Techniques for measuring subcellular temperatures have been developed on the basis of fluorescence detection. Studies report such techniques; for example, studies report a technique for measuring temperature on the basis of shifts in wavelength peaks in a fluorescence spectrum by using a fluorescent dye or fluorescence polymer nanoparticles, a technique for measuring temperature on the basis of shifts in wavelength peaks in a fluorescence spectrum by using quantum dots, and a technique for measuring temperature on the basis of shifts in frequency peaks in an optically detected electron spin resonance spectrum by using inorganic fluorescent particles, such as fluorescent nanodiamonds. Although these techniques exhibit relatively high spatial resolution or temperature sensitivity, they could not measure the temperature inside living organisms.

A study reports a technique for measuring the *in vivo* temperature of mice by using a fluorescent dye or rare-earth nanoparticles. However, this technique has low spatial resolution and low temperature sensitivity, and cannot measure temperature on a single-cell basis.

Citation List

Patent Literature

PTL 1: WO2014/165505A

Summary of Invention

Technical Problem

The present inventor focused on a thermometry based on peak shifts in an optically detected electron spin resonance spectrum and conducted research. Studies report that the thermometry captures the entire spectral peak and calculates the peak shift. However, this method requires time to capture the entire spectral peak, and it is thus difficult to perform real-time thermometry. To solve this problem, PTL 1 proposes a technique that measures four points of a peak, rather than capturing the entirety of the estimated spectral peak; and that calculates a peak shift from the measurement values.

Over the course of research on this multipoint measurement technique, the present inventor found that real-time thermometry in a dynamic environment (e.g., in a cell or at an individual level) involves fluctuations in the photon counts to be measured, leading to artifacts of the measured temperature. Due to the artifacts, the measured temperature significantly varies even when the actual temperature is constant.

An object of the present invention is to provide a technique capable of measuring temperature with higher precision on the basis of optically detected magnetic resonance. Preferably, an object of the present invention is to provide a technique capable of measuring changes in temperature in a cell or in an individual in real time with higher precision.

Solution to Problem

The present inventor conducted extensive research and found that there is a difference in photo-count responsivity (errors of the measurement counts of pulses derived from photons) between multiple photon counters used in multipoint measurement, and that this difference causes artifacts of the measured temperature values. The present inventor conducted further research based on this finding and found that the following method can measure temperature with higher precision: specifically, a method for measuring the temperature of an object on the basis of optically detected magnetic resonance of an inorganic fluorescent particle, the method comprising

(a) irradiating the object containing the inorganic fluorescent particle with each of multiple microwaves having different frequencies,
(b) measuring the fluorescence intensities of the inorganic fluorescent particle with individual photon counters at the time of irradiation of respective microwaves,

(c) correcting the fluorescence intensities on the basis of dependencies in the number of pulse measurements between the photon counters, and

(d) calculating the temperature of the object on the basis of the obtained fluorescence intensity with the correction values.

The present inventor conducted further research based on this finding and completed the present invention.

Specifically, the present invention includes the following subject matter.

Item 1.

A method for measuring a temperature of an object on the basis of optically detected magnetic resonance of an inorganic fluorescent particle, the method comprising

(a) irradiating the object containing the inorganic fluorescent particle with each of multiple microwaves having different frequencies,

(b) measuring fluorescence intensities of the inorganic fluorescent particle with individual photon counters at the time of irradiation of respective microwaves,

(c) correcting the fluorescence intensities on the basis of dependencies in the number of pulse measurements between the photon counters, and

(d) calculating the temperature of the object on the basis of the obtained fluorescence intensity with the correction values.

Item 2.

The method according to Item 1, wherein the inorganic fluorescent particle is diamond containing a NV center.

Item 3.

The method according to Item 1 or 2, wherein the multiple microwaves are 2 to 10 microwaves.

Item 4.

The method according to any one of Items 1 to 3, wherein the multiple microwaves are 6 microwaves.

Item 5.

The method according to any one of Items 1 to 4, wherein the inorganic fluorescent particle is tracked during the measurement.

Item 6.

The method according to any one of Items 1 to 5, wherein the object is a cell, a microorganism, or an organoid.

Item 7.

The method according to any one of Items 1 to 6, wherein a change in temperature of the object over time is measured.

Item 8.

The method according to any one of Items 1 to 7, wherein a change in temperature of the object in response to stimulation is measured.

Item 9.

The method according to any one of Items 1 to 8, wherein step (c) comprises subtracting a pre-measured dependencies in the number of pulse measurements between the photon counters from one of measurement values of corresponding two fluorescence intensities, or adding the pre-measured error to one of the measurement values of the fluorescence intensities.

Item 10.

The method according to any one of Items 1 to 9, wherein

the multiple microwaves are 6 microwaves, and step (d) comprises
assigning the correction values obtained in step (c) to the following formula:

$$\delta T_1 = \frac{\delta\omega}{\alpha} \frac{(I_1 + I_3) - (I_4 + I_6)}{(I_1 - I_3) - (I_4 - I_6)}$$

$$\delta T_2 = \frac{\delta\omega/2}{\alpha} \frac{(I_2 + I_3) - (I_4 + I_5)}{(I_2 - I_3) - (I_4 - I_5)}$$

$$\delta T_3 = \frac{\delta\omega/2}{\alpha} \frac{(I_1 + I_2) - (I_5 + I_6)}{(I_1 - I_2) - (I_5 - I_6)}$$

and

$$\delta T_{NV} = \frac{(T_1 + T_2 + T_3)}{3}$$

wherein $\alpha$ represents temperature dependence of a luminescent center (NV), $\delta\omega$ represents a difference in frequency between first and third microwaves, or between fourth and sixth microwaves in the order from low frequency, and $I_1$ to $I_6$ individually represent a correction value obtained by irradiation with the respective 6 microwaves, and calculating a change in temperature ($\delta T_{NV}$) in a luminescent center.

Item 11.

A thermometer for measuring a temperature of an object on the basis of optically detected magnetic resonance of an inorganic fluorescent particle, the thermometer comprising

(A) a microwave irradiator,
(B) a photon counting optical detector,
(C) a computing unit configured to correct a fluorescence intensity, and
(D) a computing unit configured to calculate a temperature.

Item 12.

The thermometer according to Item 11, further comprising (E) a particle-tracking system.

Advantageous Effects of Invention

The present invention provides a technique capable of measuring temperature with higher precision on the basis of optically detected magnetic resonance.

Brief Description of Drawings

Fig. 1(a) is a graph showing an example of an ODMR spectrum. Fig. 1(b) is a graph showing an example of temperature dependence of peak values in an ODMR spectrum.

Fig. 2 is a diagram of an ODMR spectral peak.

Fig. 3 shows a schematic diagram of the optical arrangement and microwave circuit of a device used in the ODMR thermometry in the Examples. NDF: ND filter. LLF: laser-line filter. HWP: half-wave plate. L: lens. DBS: dichroic beamsplitter. LPF: longpass filter. CCD: charge-coupled device camera. BS: beamsplitter. APD: avalanche photodiode. SPA: spectrum analyzer. MW: microwave source. DAQ: data-acquisition board. SpinCore: bit pattern generator.

Fig. 4 shows the fluctuations of photo-responsivity of counters.

Fig. 4(a) shows the photon counts of each counter (I1 to 16) as a function of laser excitation power of ND fluorescence.

Fig. 4(b) shows the difference of photon counts between two counters (i.e., (I1, 16), (I2, 15), and (I3, 14)) as a function of I1, I2, and I3, respectively. The solid line represents a quadratic polynomial approximation to the data.

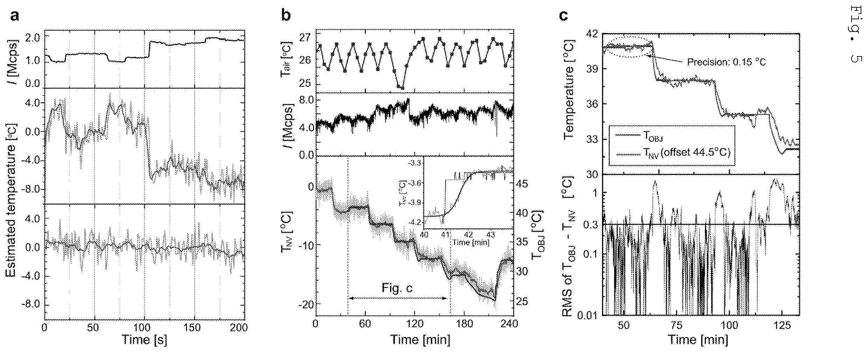

Fig. 5 shows the development of real-time fast thermometry and the results of characterization. Fig. 5(a): A time profile of the photon counts of all counters (top) over a period of 200 seconds accompanied by anthropogenic events of fluorescence intensity changes at a sampling rate of 500 ms. The corresponding estimated temperature profile of the ND-NV center is shown for both cases: a counter without calibration (middle) and a counter with calibration (bottom). Gray: $T_{NV}$ every second. Red: the moving average in 34 seconds. Fig. 5(b) shows ambient air temperature along with the stepwise change in temperature of a microscope objective heater ($T_{OBJ}$) ($T_{Air}$, top), detected total photon counts (middle), and a time profile of $T_{NV}$ (bottom). The inset is a magnified view showing a transient temperature rise by 0.7°C at a time constant of 19 seconds. Gray: $T_{NV}$ every second, Red: the moving average in 34 seconds, Blue: $T_{OBJ}$. Fig. 5(c) is a magnified view of $T_{NV}$ (top) and RMS of ($T_{NV}$-$T_{OBJ}$) (bottom) from 38 to 140 minutes. The precision is 0.3°C, which is indicated by a solid line.

Fig. 6 shows microscopic photographs of an ND-labeled nematode worm. Fig. 6(a): DIC, Fig. 6(b): green, Fig. 6(c): red confocal fluorescence, and Fig. 6(d): their merged image.

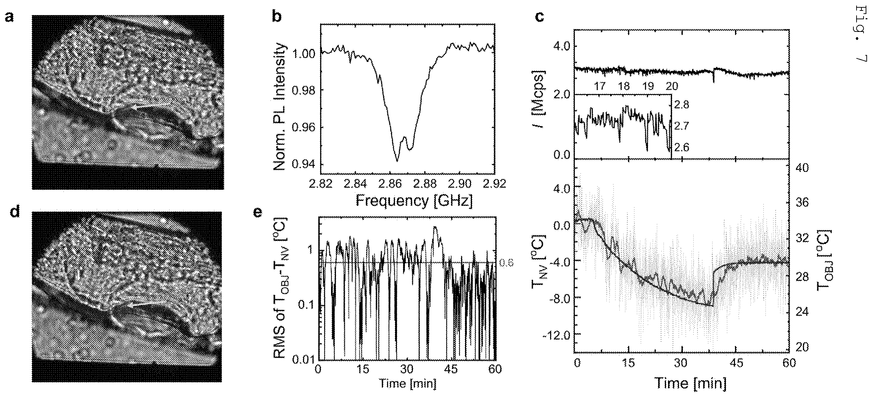

Fig. 7 shows the results of *in vivo* temperature measurement of a nematode during the changes in environmental temperature. Fig. 7(a) shows a merged photograph of NDs in the worm near internal larva. The yellow arrow indicates the ND used in temperature measurement. The black shadow seen in the bottom part indicates a copper-wire microwave linear antenna. Fig. 7(b) shows a CW-ODMR spectrum of ND. Fig. 7(c) shows a time profile of the photon counts and $T_{NV}$ during environmental change. The inset is a magnified view showing photon counts frequently repositioned every 4 seconds. Approximately every minute, a substantial position correction is seen. Gray: $T_{NV}$ every second, Red: the moving average in 34 seconds, Blue: $T_{OBJ}$. Fig. 7(d) shows a merged photograph after measurement. Fig. 7(e) shows RMS of ($T_{NV}$-$T_{OBJ}$) relative to temperature change. The precision is 0.6°C, which is indicated by a solid line.

Fig. 8 shows a temperature rise of a nematode caused by biochemical stimulation using FCCP. Fig. 8(a) shows the photon counts (top) and $T_{NV}$ (bottom) during stimulation by FCCP. The dashed blue line is a baseline estimated from a control experiment. The inset shows $T_{NV}$ excluding the baseline. Fig. 8(b) shows merged photographs of bright fields captured at multiple points indicated by 1 to 5 in Fig. 8(a), and red fluorescence.

Description of Embodiments

In the present specification, the terms "comprise," "contain," and "include" include the concepts of "comprising," "containing," "including," "consisting essentially of," and "consisting of."

In an embodiment, the present invention relates to a method for measuring the temperature of an object on the basis of optically detected magnetic resonance of an inorganic fluorescent particle, the method comprising

(a) irradiating the object containing the inorganic fluorescent particle with each of multiple microwaves having different frequencies,

(b) measuring the fluorescence intensities of the inorganic fluorescent particle with individual photon counters at the time of irradiation of respective microwaves,

(c) correcting the fluorescence intensities on the basis of dependencies in the number of pulse measurements between the photon counters, and

(d) calculating the temperature of the object on the basis of the obtained fluorescence intensity with the correction values (in the present specification, "the measurement method of the present invention"). This method is described below.

## 1. Measurement Method Based on Optically Detected Magnetic Resonance

The measurement method of the present invention is a method for measuring the temperature of an object on the basis of optically detected magnetic resonance ("ODMR" below) of inorganic fluorescent particles. The ODMR is described below.

Inorganic fluorescent particles absorb the microwave of a resonance frequency and show electron spin resonance. Inorganic fluorescent particles have properties such that non-radiant energy inactivation is increased in their electronic excitation state during electron spin resonance. Thus, the amount of fluorescence decreases during microwave irradiation compared with that without microwave irradiation. In the NV center of a diamond, when the external magnetic field is a zero magnetic field, the electron spin resonance occurs at frequency F of 2.87 GHz.

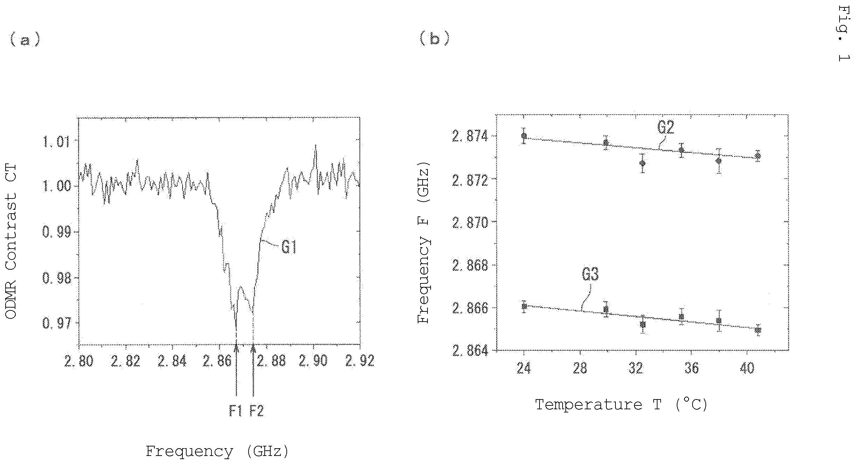

Fig. 1(a) is a graph showing an example of an ODMR spectrum. Fig. 1(b) is a graph showing an example of temperature dependence of peak values in an ODMR spectrum. As indicated by G1 in Fig. 1(a), irradiation with a microwave having frequency F near 2.87 GHz attenuates the amount of fluorescence by about 0.03. The separation of two peaks (minimal value) is due to the effect of crystal strain. The first frequency F1 and the second frequency F2 are each the frequency at which the amount of fluorescence reaches a minimum value. The second frequency F2 is greater than the first frequency F1. In the graph of Fig. 1b, the horizontal axis shows temperature T, and the vertical axis shows the frequency of the ODMR spectral peak. Temperature T indicates the ambient temperature around inorganic fluorescent particles. G2 shows the change of the second frequency F2 relative to the change of temperature T. G3 shows the change of the first frequency F1 relative to the change of temperature T. As shown by G2 and G3, the ODMR spectral peak shifts with the change of ambient temperature. Thus, the temperature can be measured based on this peak shift.

## 2. Step (a)

In step (a), an object containing inorganic fluorescent particles is irradiated with each of multiple microwaves having different frequencies.

The inorganic fluorescent particles can be any inorganic fluorescent particles that have electron spin activity. Specifically, examples include diamond, silicon carbide, zinc oxide, and two-dimensional substances (e.g., hexagonal boron nitride). Of these, diamond (in particular, nanosize diamonds, mean particle size: less than 1000 nm, "nanodiamond") is preferable.

The diamond can be either a single crystal or a polycrystal. Synthetic diamonds includes those made by CVD, a high-pressure high-temperature process, detonation, etc. The diamond includes diamonds of Type I and Type II (Type IIa, Type Iib, etc.).

The shape of the diamond is not limited. The diamond can be, for example, in the form of particles, thin films, or sheets. The size depends on the shape; for example, if diamond is in a particulate form, the mean particle size can be, for example, 1 nm to 500 nm. The mean particle size is preferably about 10 to 200 nm, and more preferably about 30 to 150 nm.

The diamond preferably contains the NV center (a luminescent center formed by combining a nitrogen atom present as impurities with a vacancy lacking a carbon atom in an appropriate position; NV center-containing diamond). The NV center may be the one naturally occurring or artificially introduced. The method for artificially introducing an NV center can be any method; examples include a technique of annealing after introducing nitrogen atoms, and a technique of introducing nitrogen atoms during the synthesis of diamond by chemical vapor deposition (CVD).

The diamond can also be surface-modified. The method for surface modification is not particularly limited. For example, diamond can be surface-modified as follows: diamond is optionally treated under strong oxidation conditions to convert the carbon groups on the surface to carboxy groups; or diamond is reduced to introduce hydroxy groups; or other functional groups (e.g., amino and thiol) are introduced according to or in accordance with a known method. Then, various molecules or substances are linked to the diamond through these groups. Surface-modifying molecules can be any molecules, and examples include water-soluble polymers, such as polyglycerol and polyethylene glycerol, and various low-molecular-weight compounds such as proteins, peptides, nucleic acids, and pharmaceutical compounds.

The inorganic fluorescent particles may be a single kind of particles, or a combination of two or more kinds.

The object is the target of temperature measurement, and is not limited. The object is, for example, preferably cells, microorganisms, and organoids. The interior of these measurement targets is a dynamic environment, and this causes fluctuations in the measured photon counts, thus leading to artifacts in the measured temperature values when real-time temperature measurement is performed. The measurement method of the present invention enables high-precision temperature measurement of even such objects.

The cells can be any cells, and are, for example, vascular endothelial cells, endothelial progenitor cells, stem cells (e.g., stem cells derived from bone marrow, stem cells derived from adipose tissue, mesenchymal stem cells, and pluripotent stem cells, such as iPS cells and ES cells), muscle cells (skeletal muscle cells, smooth muscle cells, and cardiomyocytes), muscle progenitor cells (e.g., myocardial progenitor cells, and myoblasts), immune cells (e.g., T cells), and nerve cells.

The microorganisms can be any organisms invisible to the naked eye, or organisms that are visible to the naked eye but have an unidentifiable structure, such as bacteria, unicellular organisms, planktons, larvae, and nematodes.

The organoids include cerebral organoids, cerebellar organoids, inner-ear organoids, thyroid organoids, thymic organoids, testicular organoids, hepatic organoids, spleen organoids, intestinal organoids, epithelial organoids, lung organoids, kidney organoids, and embryos.

The object containing inorganic fluorescent particles may have the inorganic fluorescent particles inside the object or have the inorganic fluorescent particles attached outside the object, and the former is preferable. In the former case, the influence of noise on measurement due to the internal environment of the object is greater. However, the measurement method of the present invention can still measure the temperature with higher precision even in this case. The object containing inorganic fluorescent particles can be obtained by various methods. For example, if the object is a cell, the inorganic fluorescent particles can be incorporated into the cell by bringing the particles into contact with the cell.

The amount of inorganic fluorescent particles in the object can be suitably determined, for example, according to the type of the object, or the type of the inorganic fluorescent particles. For example, in the case of nematodes with a body length of about 1 mm, the amount of inorganic fluorescent particles to be introduced into a single nematode is, for example, 1 to 100 ng.

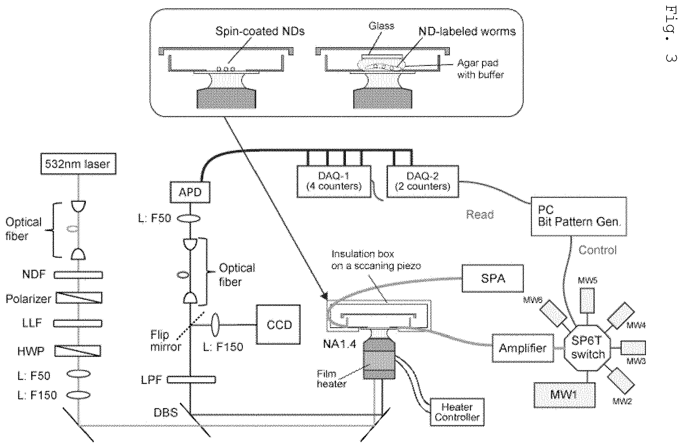

The object containing inorganic fluorescent particles is positioned so that excitation light irradiation, micro-light irradiation, and fluorescence collection are possible in order to perform the temperature measurement of the present invention. Specifically, the object is placed on a sample table above an objective in a device as shown in Fig. 3.

In the measurement method of the present invention, the microwaves for irradiation are multiple microwaves having different frequencies from each other.

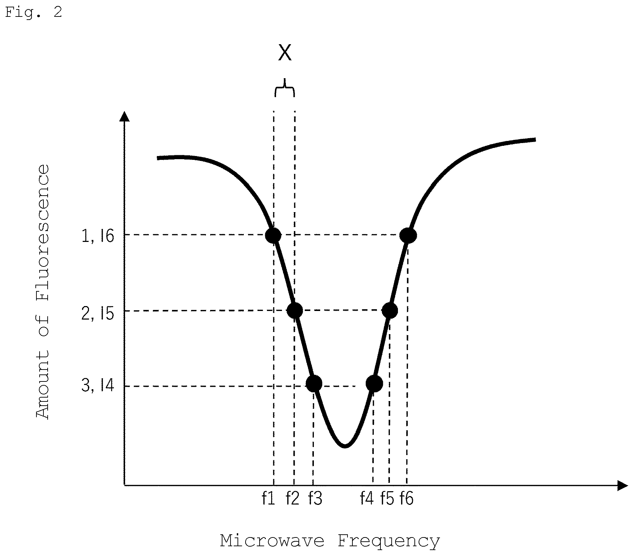

The frequency of microwaves is typically 9 GHz or below, and selected from a frequency range in which a linear approximation is shown on both sides of an assumed ODMR spectral peak (see Fig. 2). The frequency range is preferably determined before measurement, according to the type of the inorganic fluorescent particles and the type of the object. The number of microwave frequencies is typically an even number; from the standpoint of, for example, measurement precision, and measurement efficiency, the number of microwaves is preferably 2 to 10, more preferably 4 to 10, still more preferably 6 to 8, and particularly preferably 6. The frequency of each microwave on one side of an ODMR spectral peak is preferably set such that the amount of fluorescence measured is comparable with the amount of fluorescence measured at each corresponding microwave frequency on the other side of the spectral peak (see Fig. 2). Specifically, in Fig. 2, frequency f1 is preferably designed so that the measured fluorescence intensity (I1) is comparable to the measured fluorescence intensity (I6) at the corresponding frequency (f6). The difference in frequency between microwaves (e.g. X in Fig. 2) on one side of the ODMR spectral peak is preferably 1 to 5 MHz.

The irradiation time period of each microwave of each frequency for one time is not particularly limited. From the standpoint of measurement precision and measurement efficiency, the irradiation time period is, for example, 10 $\mu$s to 1000 $\mu$s, preferably 30 $\mu$s to 300 $\mu$s, and more preferably 50 $\mu$s to 200 $\mu$s. The irradiation time period of each microwave is preferably equivalent between microwaves; for example, the longest irradiation time period relative to the shortest irradiation time period is, for example, preferably 200% or less, 150% or less, 120% or less, or 110% or less.

Irradiation of the microwaves having different frequencies is typically repeated. For example, in the example in Fig. 2, after irradiation of microwaves is performed in the order of frequency f1, frequency f2, frequency f3, frequency f4, frequency f5, and frequency f6, irradiation of microwaves are performed again in the order of frequency f1, frequency f2, frequency f3, frequency f4, frequency f5, and frequency f6; and this cycle is repeated. The change in temperature of the object over time can be measured by continuously repeating this cycle for a predetermined period of time (e.g., 1 minute or more, 5 minutes or more, 10 minutes or more, 20 minutes or more, 30 minutes or more, 60 minutes or more, 2 hours or more, 5 hours or more, or 8 hours or more).

Microwave irradiation is performed by using a suitable microwave source. Repeated irradiation of microwaves having different frequencies can be performed, for example, by preparing multiple microwave sources for respective frequencies, coupling the microwave sources to a switching device, and operating the switching device such that the microwave sources are switched sequentially at a predetermined point of time. The microwaves generated from the microwave sources are typically passed through an amplifier to be amplified and then irradiate the object.

In step (a), the object containing inorganic fluorescent particles can also be stimulated. If the object is a cell, a microorganism, an organoid, or the like, and the temperature changes in response to stimulation, the change in temperature can be measured. The type of the stimulus is not particularly limited, and can be, for example, culture conditions (e.g. changes in temperature, pH, or light conditions), or the addition of a test substance. The test substance can be any substance, and includes, for example, antibodies, proteins, nucleic acids, physiologically active substances, vesicles, bacteria, viruses, polypeptides, haptens, therapeutic agents, and metabolites of therapeutic agents.

3. Step (b)

In step (b), the fluorescence intensity of the inorganic fluorescent particles during irradiation of each microwave is measured with an individual photon counter.

The fluorescence intensity of the inorganic fluorescent particles is measured typically by irradiating the inorganic fluorescent particles with a microwave and excitation light of the particles, and measuring the intensity (I1, I2, etc.) of the fluorescence (fluorescence L1, L2, etc.) at the time of irradiation of the microwave (frequency f1, f2, etc.). The wavelength of the excitation light varies depending on the type of the inorganic fluorescent particles, and can be set accordingly. For example, if NV center-containing diamond is used, the wavelength of the excitation light is, for example, 490 to 580 nm, and preferably 520 to 560 nm. The wavelength of fluorescence also varies depending on the type of the inorganic fluorescent particles. For example, if NV center-containing diamond is used, the wavelength of fluorescence is, for example, 637 to 800 nm. The irradiation of excitation light and detection of fluorescence are performed, for example, as follows. A continuous-wave laser of a typical excitation intensity is used for excitation. A microscope objective is used for both excitation and fluorescence collection. Fluorescence is extracted (e.g., by a splitter such as a dichroic beamsplitter or a filter such as a longpass filter), and then detected by optionally coupling the fluorescence to an optical fiber that serves as a pinhole, or by using a pinhole, with a photodiode such as an avalanche photodiode or other optical detectors.

The fluorescence intensity of the inorganic fluorescent particles during irradiation of various microwaves are measured with individual photon counters. In other words, the intensity of the fluorescence (fluorescence L1, L2, etc.) at the time of irradiation of various microwaves (frequency f1, f2, etc.) is measured with individual photon counters (counter 1 for the intensity of fluorescence L1, counter 2 for the intensity of fluorescence L2, etc.). The photon counters for use can be any counters, and various counters can be used. The photon counters for use each may be a single counter installed only in a single independent measurement device; or the photon counters may be multiple counters installed in a measurement device. Multiple measurement devices may also be used in combination to prepare a necessary number of counters (the number of microwaves). The fluorescence intensity (I1, I2, etc.) of the inorganic fluorescent particles under irradiation of various microwaves can be determined by measuring it with individual photon counters (counter 1 for the intensity of fluorescence L1, counter 2 for the intensity of fluorescence L2, etc.).

The fluorescence intensity may be an absolute value or a relative value.

The target of measurement is typically a single inorganic fluorescent particle. However, multiple particles can also be measured simultaneously. If the inorganic fluorescent particles move during the measurement, the particle to be measured can be continuously tracked by tracking the inorganic fluorescent particles. This allows for the measurement of changes in temperature over time with higher precision. The particles can be tracked by any method, and can be tracked by using a known tracking technique.

4. Step (c)

In step (c), the fluorescence intensity is corrected based on the errors of the number of pulse measurements between the photon counters.

The present inventor found that there is a difference in photon count responsivity (the photon-derived errors in the number of pulse measurements) between multiple photon counters, and that this causes artifacts in temperature measurement values in performing real-time thermometry in a dynamic environment such as in a cell or at an individual level. Thus, temperature can be measured more precisely by correcting the errors.

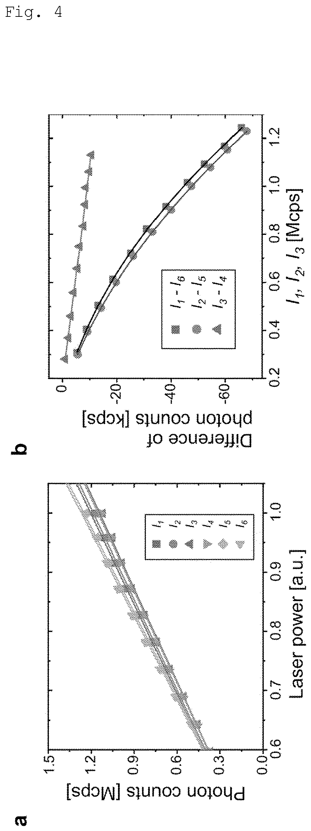

The errors in the number of pulse measurements between photon counters are preferably measured beforehand. The measurement of errors is not limited, and can be performed, for example, as follows. Inorganic fluorescent particles are irradiated with each of multiple microwaves having different frequencies for use in thermometry by increasing the intensity of multiple laser beams stepwise (e.g., 3 to 20, 4 to 15, and 6 to 12). Then, the photon counts (p1, p2, etc.) of the fluorescence (fluorescence L1, L2, etc.) at the time of irradiation of each microwave (frequency f1, f2, etc.) are measured with an individual separate photon counter (counter 1 for the photon counts of fluorescence L1, counter 2 for the photon counts of fluorescence L2, etc.). The error in measured values (the difference in photon counts measured under the same conditions) between corresponding two photon counters is calculated based on the measured values. The phrase "corresponding two photon counters" refers to two counters (counter 1 and counter 6, counter 2 and counter 5, and counter 3 and counter 4) for measurement of the corresponding frequencies (see Fig. 2; f1 and f6, f2 and f5, and f3 and f4) on both sides of an ODMR spectral peak assumed in temperature measurement. A graph showing errors in measurement values as shown in Fig. 4 can be obtained, for example, by polynomial fitting based on the measurement values.

The fluorescence intensities obtained in step (b) are corrected based on the errors. The fluorescence intensity can be corrected by any method. For example, a corrected value (corrected value c1, c2, etc.) can be obtained by subtracting an error from one of the measurement values of corresponding two fluorescence intensities (see Fig. 2, I1 and I6, I2 and I5, and I3 and I4), or by adding the error to one of the measurement values of the fluorescence intensities.

Specifically, step (c) includes, for example, subtracting a pre-measured error of the number of pulse measurements between the photon counters from one of the measurement values of corresponding two fluorescence intensities, or adding the pre-measured error to one of the measurement values of the corresponding two fluorescence intensities.

5. Step (d)

In step (d), the temperature of the object is calculated on the basis of the obtained correction values.

The temperature of the object can be calculated by any method, and can be calculated according to or in accordance with a known method. When 4 different microwaves are used, the temperature can be calculated, for example, according to the method disclosed in PTL 1. When 6 different microwaves are used, the temperature can be calculated, for example, according to the method disclosed in PTL 1, for two combinations of corresponding two correction values (a combination of c1-c6 and c2-c5, a combination of c2-c5 and c3-c4, and a combination of c1-c6 and c3-c4) that have substantially the same value (c1-c6, c2-c5, c3-c4) out of the 6 correction values respectively corresponding to 6 frequencies; and the average can be taken as the final measurement value. Specifically, the temperature can be calculated, for example, according to the method and formula used in the Examples, described later (section "1. Thermometry").

Specifically, when 6 different microwaves are used, step (d) includes assigning, for example, the correction value obtained in step (c) to the following formula:

$$\delta T_1 = \frac{\delta\omega}{\alpha} \frac{(I_1 + I_3) - (I_4 + I_6)}{(I_1 - I_3) - (I_4 - I_6)}$$

$$\delta T_2 = \frac{\delta\omega/2}{\alpha} \frac{(I_2 + I_3) - (I_4 + I_5)}{(I_2 - I_3) - (I_4 - I_5)}$$

$$\delta T_3 = \frac{\delta\omega/2}{\alpha} \frac{(I_1 + I_2) - (I_5 + I_6)}{(I_1 - I_2) - (I_5 - I_6)}$$

*and*

$$\delta T_{NV} = \frac{(T_1 + T_2 + T_3)}{3}$$

wherein $\alpha$ represents the temperature dependence of the luminescent center (NV), $\delta\omega$ represents the difference in frequency between first and third microwaves, or between fourth and sixth microwaves in the order from low frequency, and $I_1$ to $I_6$ individually represent the correction value obtained by irradiation with the respective 6 microwaves, and calculating the change in temperature ($\delta T_{NV}$) in the luminescent center.

The temperature can be measured with higher precision by taking the average of temperatures for a predetermined period of time. Irradiation with microwaves having different frequencies is typically repeated (e.g., in the example of Fig. 2, irradiation of microwaves in the order of frequency f1, frequency f2, frequency f3, frequency f4, frequency f5, and frequency f6 is performed, followed by irradiation of microwaves in the order of frequency f1, frequency f2, frequency f3, frequency f4, frequency f5, and frequency f6; and this cycle is repeated). In this case, for example, the average of the temperatures calculated from each cycle within a predetermined period of time (e.g., 0.1 to 180 seconds, 0.3 to 120 seconds, 1 to 100 seconds, 3 to 100 seconds, 10 to 80 seconds, and 20 to 50 seconds) (e.g., neighboring average, and moving average) can be taken as a measurement value.

The technique described above enables, for example, the real-time high-precision measurement of a nanoscale thermal event, the measurement of metabolism of an individual, a test of the effects of a health food such as for fat-burning, or thermal measurement of metabolic changes caused by a drug.

The measurement method of the present invention can be performed by using a thermometer including (A) a microwave irradiator, (B) a photon counting optical detector , (C) a computing unit configured to correct the fluorescence intensity, and (D) a computing unit configured to calculate the temperature (in the present specification, "the measurement device of the present invention").

The microwave irradiator and the photon counters are as described above.

The computing unit configured to correct the fluorescence intensity and the computing unit configured to calculate the temperature may be a single computing unit, or separate individual computing units.

The computing unit configured to correct the fluorescence intensity acquires information of the fluorescence intensities measured by the photon counters, and corrects the values on the basis of the errors of the number of pulse measurements between the photon counters. The computing unit configured to calculate the temperature acquires information of the obtained correction values and calculates the temperature. The detailed processing in these computing units are as described above, and the processing is executed by a pre-stored computer program.

The measurement device of the present invention preferably further includes a particle-tracking system. The particle-tracking system for use can be a system using a known particle tracking technique (e.g., piezo stages).

The measurement device of the present invention may be an all-in-one device that can perform the measurement method of the present invention alone, by further including, for example, a sample table on which the object containing inorganic fluorescent particles is to be placed, a microscope objective, a fluorescence irradiator, and a display to show the calculated temperature information.

Examples

The following describes the present invention in detail with reference to Examples. However, the present invention is not limited to these Examples.

1. Thermometry

ODMR thermometry in Examples is described. Fig. 3 shows a schematic diagram of a device. For excitation, a continuous-wave (532 nm) laser with a typical excitation intensity of ca. 5 kW·cm$^{-2}$ was used. An oil-immersion microscope objective with a numerical aperture of 1.4 was used for both excitation and fluorescence collection. The NV fluorescence was filtered using a dichroic beamsplitter (Semrock, FF560-FDi01) and a longpass filter (Semrock, BLP01-561R, or BLP01-635R-25) to remove residual green laser scattering. The fluorescence was then coupled to an optical fiber (Thorlabs, 1550HP, core diameter: about 10 $\mu$m) working as a pinhole. The fiber-coupled fluorescence was ultimately detected by an avalanche photodiode (APD, Perkin Elmer SPCM AQRH-14). The sample was placed on a piezo stage capable of raster scanning and particle tracking. The APD output was fed to two data-acquisition boards, one equipped with four pulse counters (DAQ-1BNC, National Instruments), the other equipped with two pulse counters (DAQ-2BNC, National Instruments). Photon counting measurements except for 6-point measurement were all performed with a DAQ board (USB-6343BNC). The fluorescence spectra were measured with a spectrometer equipped with a liquid-nitrogen-cooled charge-coupled device camera (Princeton, LNCCD). A fiber-pigtail beamsplitting system was inserted into an optical fiber cable, and spectrum measurement and particle tracking were simultaneously performed to prevent chromatic aberration caused by the motion of particles.

To implement both the CW- and multipoint-ODMR measurements, a stand-alone microwave source (Rohde & Schwarz, SMB100A) and five USB-powered microwave sources (Texio, USG-LF44) were coupled to an SP6T switch with a switching time of 250 ns (General Microwave, F9160). The microwave was then amplified (Mini-circuit, ZHL-16W-43+) and fed to a linear microwave antenna placed on a coverslip (25-$\mu$m-thin copper wire), and sealed with a cell-culture dish having a hole at the center. The typical microwave excitation power was estimated to be 5[A/m] as a magnetic field strength, given the input power and output power of the antenna, as well as electromagnetic simulation by a finite-element method (COMSOL). In the CW-ODMR measurement, APD detection was gated for microwave irradiation ON and OFF using the SP6T switch and a bit pattern generator (SpinCore, PBESR-PRO-300), where the gate width was 200 $\mu$s for both gates, followed by a laser shut-off time of 100 $\mu$s, resulting in $I_{PL}^{ON}$ and $I_{PL}^{OFF}$ with a repetition rate of 2 kHz. An external magnetic field was not applied in the Examples. In the multipoint ODMR measurements, APD detection was gated for the corresponding microwave frequencies where the gate width was 100 $\mu$s, which was common for all six gates, each followed by an interval of 5 $\mu$s. The obtained number of photons at each of the 6 frequencies was assigned to the following formula to calculate an estimated value of the temperature ($T_{NV}$) of an NV center.

$$\delta T_1 = \frac{\delta\omega}{\alpha} \frac{(I_1 + I_3) - (I_4 + I_6)}{(I_1 - I_3) - (I_4 - I_6)}$$

$$\delta T_2 = \frac{\delta\omega/2}{\alpha} \frac{(I_2 + I_3) - (I_4 + I_5)}{(I_2 - I_3) - (I_4 - I_5)}$$

$$\delta T_3 = \frac{\delta\omega/2}{\alpha} \frac{(I_1 + I_2) - (I_5 + I_6)}{(I_1 - I_2) - (I_5 - I_6)}$$

*and*

$$\delta T_{NV} = \frac{(T_1 + T_2 + T_3)}{3}$$

wherein $\alpha$ represents the temperature dependence of the NV center, -74 kHz·°C$^{-1}$.

## 2. 6-Point Measurement and ODMR Peak Shift Due to Temperature

### Change

To enable a nanodiamond quantum thermometry *in vivo,* a real-time *in vivo* thermometry system based on a confocal fluorescence microscope equipped with a fast particle tracking and high-precision temperature estimation protocol was developed (see section "1. Thermometry" above and Fig. 3). In particle tracking, the system measures the fluorescence intensity along the xyz axes and focuses on the respective fluorescence maximum every time. Repositioning typically takes 2.8 seconds, and repeats every 4 seconds.

High-precision quantum thermometry is based on the detection of a temperature-dependent peak shift of an optically detected magnetic resonance (ODMR) line in the nitrogen-vacancy (NV) centers in NDs. In particular, this study used a multipoint ODMR measurement protocol for measuring the fluorescence intensity using 6 frequencies located symmetrically with respect to an ODMR peak. The fluorescence intensities at 4 frequency points out of the 6 points give 3 groups of temperature estimation according to the formula shown in section "1. Thermometry" above, and the average of the estimation ultimately gives an estimated temperature value. Experimentally, six frequencies are output sequentially from a frequency selector with a pulse width of 100 $\mu$s and an interval of 5 $\mu$s. These timing-controlled microwave pulse trains are sent to a microwave antenna prepared on a cell-culture dish. NDs or ND-labeled nematode worms are placed on the cell-culture dish.

The advantage of choosing 6 points instead of the previously reported 4 points (PTL 1) is the improvement in precision of temperature. Compared to selecting 4 points with the same photon flux, a six-point analysis uses two-thirds of the photon counts per second while performing 4-point analysis three times, thus reducing measurement noise (formula below).

$$\left(\sqrt{2/3}\right)^{-1} \times \left(\sqrt{3}\right)^{-1} = \left(\sqrt{2}\right)^{-1} = 0.7$$

In fact, as the number of frequency points increases, more details about the ODMR spectral shape are obtained. This is useful for detailed analysis of temperature profiles. In this study, the moving average was used. However, more advanced data estimation, such as Kalman filtering, can also be effective.

It was found to be important to calibrate the photon-counting responsivity of each pulse counter to achieve real-time monitoring in a dynamic environment. Each counter was found to have a very small difference in photo-responsivity of <5% (see Fig. 4). Fig. 4a shows the counter values of NV fluorescence at six frequencies (I1 to I6) as functions of excitation laser output. Ideally, I1, I2, and I3 should indicate the same response gradient as that of corresponding I4, I5, and I6. Fig. 4b shows their differences (I1-I6, I2-I5, and I3-I4) as functions of the photon counts in I1, I2, or I3. In the following test, a counter calibration was performed to compensate for this misalignment (error).

First, the temperature of NDs placed on a cover glass was measured (see Fig. 3). As shown in Fig. 5a, the stepwise change in the photon counts caused artifacts in the estimated value of temperature of an NV center, despite the actual temperature undergoing no change. By calibrating I1 to I6 (I2 to I5 and I3 to I4) over the full range of photon counts used in the experiment, noise and drifts were significantly decreased. With these counter calibrations, the temperature measurement was no longer affected by fluctuations of the photon counts.

Second, the specifications of thermometry (precision, accuracy, temporal resolution, and stability) were evaluated by changing the temperature of the microscope objective ($T_{OBJ}$) stepwise within the range of 20 to 40°C (Fig. 5b). The temperature was first at 44.0°C and was lowered to 40.2°C. The temperature was then raised slightly to 40.9°C at a point of 40.7 minutes. Importantly, $T_{NV}$ was able to clearly detect this small temperature change of only 0.7°C, as shown in the inset in Fig. 5b. This temperature transition occurred at a characteristic time constant of 19 seconds in practical Boltzmann fitting and completed in about 1.5 minutes. The time difference between $T_{OBJ}$ and $T_{NV}$ is 1.2 minutes, and this demonstrates that the nanodiamond thermometer can detect a transient temperature change of 1°C or less in real time.

In the lower temperature range of below 35°C, a difference appeared between $T_{NV}$ and $T_{OBJ}$. This difference is due to the insufficient waiting time for $T_{OBJ}$ to become thermalized completely, and is irrelevant to the precision of the thermometer. Rather, the difference is an accurate reflection of the actual temperature of the surface of the cover glass. This is because heat dissipation is proportional to the difference from room temperature according to Fourier's law. It takes more than an hour to reach a complete thermal equilibrium.

Heating the objective of a microscope results in more substantial fluctuations and drifts of the focal position than lowering the temperature. Thus, to show the robustness of the thermometer, the heater was turned off in 207 minutes and then turned on in 218 minutes to increase the temperature to 35°C. During this rapid thermal event, the system was able to track the ND position while indicating a correct temperature estimate. Given the stepwise change within the range of 35 to 45°C, the precision of the current temperature measurement was determined to be 0.16°C based on an integral time of 34 seconds, which is less than 0.3°C in the root mean square (Fig. 5c). Thus, the sensitivity was $1.6°C/\sqrt{Hz}$. Such a small net precision in real time is a remarkable feature of current nanoscale thermometers, and this is a key milestone for biological *in vivo* applications.

<u>3. Temperature Measurement in Living Nematode</u>

Because a robust and accurate thermometry that operates in real time was established, a local temperature monitoring of living worms was tested. NDs used for labeling nematodes were highly water-soluble nanodiamonds coated with polyglycerol (nanodiamonds obtained by coating nanodiamonds having a median particle size of 100 nm (Adams nanotechnology) with polyglycerol). These NDs were introduced into the gonad of the worms by microinjection and incubated overnight to wait for the NDs to be incorporated into the cells. The labeled worms were anesthetized and transferred to an antenna-integrated culture dish near its microwave antenna. They were sandwiched between an agar pad and a cover glass filled with buffer.

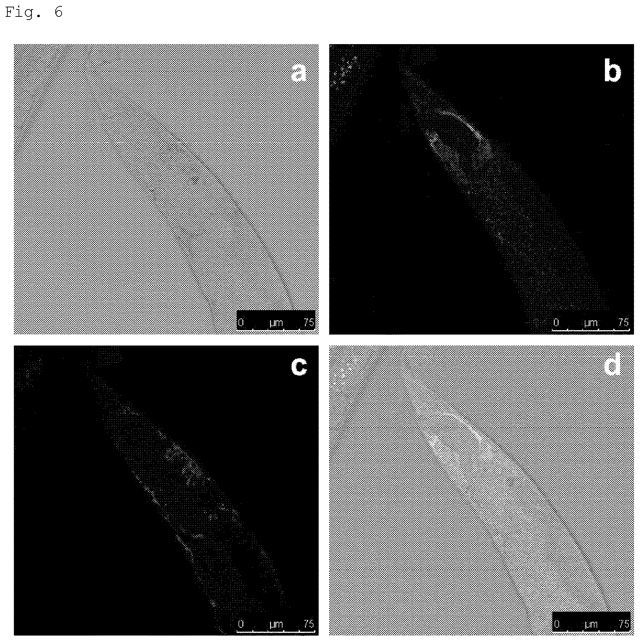

Figs. 6a to 6d respectively show the DIC (differential interference contrast), green, and red confocal fluorescence of a labeled worm, and their composite image. Because NDs are distributed over the entire area of the images, the ODMR signals of the worms in various parts could be measured. Living worms continuously move at a typical rate of about 200 nm/min, which is measured by time-lapse imaging, during temperature observation. In the following experiment, these NDs were continuously tracked while the local temperatures were measured.

Figs. 7a and 7b show merged microscope photographs of a single ND indicated by an arrow near an embryo and cw-ODMR spectra. The contrast of the ODMR is generally weak in worms due to background fluorescence. Typically, compared with 0.88 on coverslips, an ODMR contrast of 0.9 to 0.94 is obtained in worms. From this fact, the intensity of background fluorescence was estimated to be 0.6 to 1.0 times the ND fluorescence. Fig. 7c shows a time profile of $T_{NV}$ over a period of 1 hour during the course of temperature change caused by a microscope-objective heater. $T_{OBJ}$ was initially set to 34.0°C (RT = 21.5°C at this point in time). In 5 minutes, the heater was turned off, and $T_{NV}$ was gradually decreased toward RT. In 38.7 minutes, the heater was turned on and adjusted to 29.5°C. The measurement profile of TNV (red) was in good agreement with that of TOBJ (blue). The precision and accuracy of this *in vivo* measurement were respectively ±0.39°C (integral time: 34 seconds) and <0.6°C (Fig. 7e) .

<u>4. Detection of Heat Production Response of Nematode Due to Drug Stimulation</u>

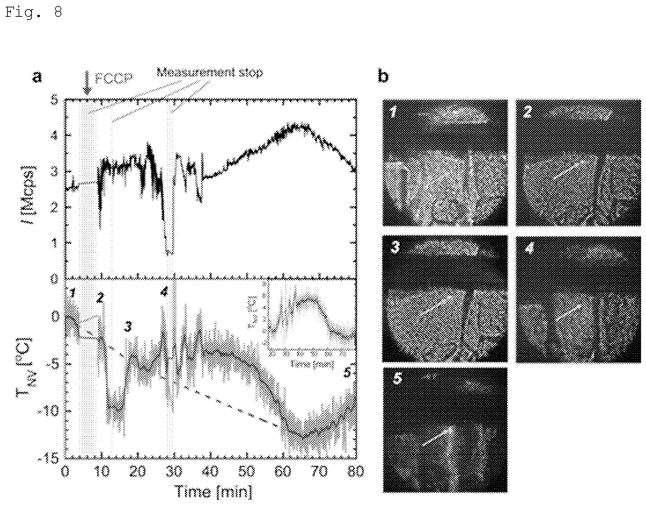

To demonstrate the applicability of this thermometry in research of *in vivo* exotherm, the internal temperature of worms stimulated by FCCP (carbonyl cyanide-trifluoromethoxy phenylhydrazone), which is a mitochondrial uncoupler, was measured. Fig. 8a shows a time profile of the internal temperature of a worm stimulated by FCCP. After the start of measurement, $T_{NV}$ continuously decreased; however, this was actually baseline drifts and frequently observed *in vivo*. After 6 minutes, a small amount of a 60 $\mu$M FCCP solution was added to the medium. Between 10 and 18 minutes, the baseline drifts of $T_{NV}$ shifted down sharply with short transition times of 4 and 12 seconds for drop and recovery, respectively. This was mainly because the tracking system mistakenly captured a nearby ND with a slightly different ODMR peak (see Fig. 8b). In 24 minutes (18 minutes after the addition of FCCP), the temperature gradually increased and reached a maximum of about 3°C in 40 to 50 minutes. Between 25 and 35 minutes, there was a strong fluctuation in the photon counts that was actually reflected in the temperature profile. During this time, the position of the ND changed greatly as the worm moved. In actuality, the embryo located at the bottom of the images moved after this period (Fig. 8b). However, the system was able to track the ND with temperature information. The ND moved beyond the adjustable range of tracking for only 2 minutes from 28 minutes to 30 minutes, and the position of the ND was lost. However, the same ND was found by wide-field fluorescence imaging, and placed back into focus; this enabled continuous monitoring of $T_{NV}$. During the period from 60 to 65 minutes in point of time, the exotherm reaction appeared to have ended. After 65 minutes, baseline drifts of $T_{NV}$ appeared to have increased in synchronization with the decrease in the photon counts. In this regard, it is known that non-radiative relaxation caused by heat is promoted as the temperature increases, and that the fluorescence of NDs decreases. Conversely, the amount of fluorescence increases as the temperature decreases. From this point of view, the fluorescence intensity is in anti-correlation with temperature information. However, the fluorescence intensity is also affected by temporal changes in the transmittance and refractive index of biological samples; accordingly, the correlation may not always be observed.

**Claims**

1. A method for measuring a temperature of an object on the basis of optically detected magnetic resonance of an inorganic fluorescent particle, the method comprising

   (a) irradiating the object containing the inorganic fluorescent particle with each of multiple microwaves having different frequencies,
   (b) measuring fluorescence intensities of the inorganic fluorescent particle with individual photon counters at the time of irradiation of respective microwaves,
   (c) correcting the fluorescence intensities on the basis of dependencies in the number of pulse measurements between the photon counters, and
   (d) calculating the temperature of the object on the basis of the obtained fluorescence intensity with the correction values.

2. The method according to claim 1, wherein the inorganic fluorescent particle is diamond containing a NV center.

3. The method according to claim 1 or 2, wherein the multiple microwaves are 2 to 10 microwaves.

4. The method according to any one of claims 1 to 3, wherein the multiple microwaves are 6 microwaves.

5. The method according to any one of claims 1 to 4, wherein the inorganic fluorescent particle is tracked during the measurement.

6. The method according to any one of claims 1 to 5, wherein the object is a cell, a microorganism, or an organoid.

7. The method according to any one of claims 1 to 6, wherein a change in temperature of the object over time is measured.

8. The method according to any one of claims 1 to 7, wherein a change in temperature of the object in response to stimulation is measured.

9. The method according to any one of claims 1 to 8, wherein step (c) comprises subtracting a pre-measured error of the number of pulse measurements between the photon counters from one of measurement values of corresponding two fluorescence intensities, or adding the pre-measured error to one of the measurement values of the fluorescence intensities.

10. The method according to any one of claims 1 to 9, wherein

    the multiple microwaves are 6 microwaves, and step (d) comprises
    assigning the correction values obtained in step (c) to the following formula:

$$\delta T_1 = \frac{\delta\omega}{\alpha} \frac{(I_1 + I_3) - (I_4 + I_6)}{(I_1 - I_3) - (I_4 - I_6)}$$

$$\delta T_2 = \frac{\delta\omega/2}{\alpha} \frac{(I_2 + I_3) - (I_4 + I_5)}{(I_2 - I_3) - (I_4 - I_5)}$$

$$\delta T_3 = \frac{\delta\omega/2}{\alpha} \frac{(I_1 + I_2) - (I_5 + I_6)}{(I_1 - I_2) - (I_5 - I_6)}$$

*and*

$$\delta T_{NV} = \frac{(T_1 + T_2 + T_3)}{3}$$

wherein $\alpha$ represents temperature dependence of a luminescent center (NV), $\delta\omega$ represents a difference in frequency between first and third microwaves, or between fourth and sixth microwaves in the order from low frequency, and $I_1$ to $I_6$ individually represent a correction value obtained by irradiation with the respective 6 microwaves, and
calculating a change in temperature ($\delta T_{NV}$) in a luminescent center.

11. A thermometer for measuring a temperature of an object on the basis of optically detected magnetic resonance of an inorganic fluorescent particle, the thermometer comprising

   (A) a microwave irradiator,
   (B) a photon counting optical detector,,
   (C) a computing unit configured to correct a fluorescence intensity, and
   (D) a computing unit configured to calculate a temperature.

12. The thermometer according to claim 11, further comprising (E) a particle-tracking system.

Fig. 1

(a)

(b)

Fig. 2

Fig. 3

Fig. 4

Fig. 5

Fig. 6

Fig. 7

EP 3 995 819 A1

Fig. 8

EP 3 995 819 A1

## INTERNATIONAL SEARCH REPORT

| | International application No. |
|---|---|
| | PCT/JP2020/024945 |

**A. CLASSIFICATION OF SUBJECT MATTER**

G01N 22/00(2006.01)i; G01K 7/32(2006.01)i; G01N 21/63(2006.01)i; G01N 24/10(2006.01)i

FI: G01N22/00 Z ZNM; G01K7/32 Z; G01N21/63 Z; G01N24/10 510Z

According to International Patent Classification (IPC) or to both national classification and IPC

**B. FIELDS SEARCHED**

Minimum documentation searched (classification system followed by classification symbols)
G01N22/00-22/04; G01K7/32; G01N21/63; G01N24/10

Documentation searched other than minimum documentation to the extent that such documents are included in the fields searched
| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)
JSTPlus/JMEDPlus/JST7580 (JDreamIII)

**C. DOCUMENTS CONSIDERED TO BE RELEVANT**

| Category* | Citation of document, with indication, where appropriate, of the relevant passages | Relevant to claim No. |
|---|---|---|
| A | HAYASHI, Kan, "Optimization of Temperature Sensitivity Using the Optically Detected Magnetic-Resonance Spectrum of a Nitrogen-Vacancy Center Ensemble", PHYSICAL REVIEW APPLIED, 2018, vol. 10, pp. 034009-1 to 034009-8, entire text, all drawings | 1-12 |
| A | CHEN, X.-D., "Temperature dependent energy level shifts of nitrogen-vacancy centers in diamond", APPLIED PHYSICS LETTERS, 2011, vol. 99, pp. 161903-1 to 161903-3, entire text, all drawings | 1-12 |

☒ Further documents are listed in the continuation of Box C. ☒ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 10 September 2020 (10.09.2020) | 24 September 2020 (24.09.2020) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

23

**INTERNATIONAL SEARCH REPORT**

| International application No. |
| --- |
| PCT/JP2020/024945 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | 西村勇姿，細胞内温度イメージングに向けたワイドフィールド光検出電子スピン共鳴測定法の構築，第66回応用物理学会春季学術講演会講演予稿集, 25 February 2019, p. 04-296(11p-M113-10), entire text, all drawings, (NISHIMURA, Yushi, "Construction of wide-field optically detected magnetic resonance method for intracellular temperature imaging", Lecture preprints of the 66th JSAP Spring Meeting, 2019) | 1-12 |
| A | JP 2017-166969 A (NEC CORP.) 21.09.2017 (2017-09-21) entire text, all drawings | 1-12 |
| A | WO 2014/165505 A1 (MAURER, Peter Christian) 09.10.2014 (2014-10-09) entire text, all drawings | 1-12 |
| A | CN 109238505 A (UNIV NANJING POSTS & TELECOMMUNICATIONS) 18.01.2019 (2019-01-18) entire text, all drawings | 1-12 |

Form PCT/ISA/210 (continuation of second sheet) (January 2015)

**INTERNATIONAL SEARCH REPORT**
Information on patent family members

| International application No. |
| --- |
| PCT/JP2020/024945 |

| Patent Documents referred in the Report | Publication Date | Patent Family | Publication Date |
| --- | --- | --- | --- |
| JP 2017-166969 A | 21 Sep. 2017 | (Family: none) | |
| WO 2014/165505 A1 | 09 Oct. 2014 | US 2016/0018269 A1 EP 2981795 A1 | |
| CN 109238505 A | 18 Jan. 2019 | (Family: none) | |

Form PCT/ISA/210 (patent family annex) (January 2015)

**EP 3 995 819 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014165505 A